# EUROPEAN PATENT APPLICATION

(11) **EP 4 712 339 A1**
(43) Date of publication of application: **18.03.2026**
(21) Application number: 23936591.9
(22) Date of filing: 10.05.2023
(51) Int. Cl.: H02S 40/34, H01L 31/0465, H02S 40/36, H10K 39/12

(54) **TERMINAL BOX, SOLAR CELL UNIT, AND SOLAR CELL UNIT CONNECTION BODY**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: ASATANI, Tsuyoshi, Kawasaki-shi, Kanagawa 212-0013 (JP); SAITA, Yutaka, Kawasaki-shi, Kanagawa 212-0013 (JP); MIYAUCHI, Hiroyuki, Kawasaki-shi, Kanagawa 212-0013 (JP)
(74) Representative: Henkel & Partner mbB
(86) International application number: PCT/JP2023/017536
(87) International publication number: WO 2024/232038

(57) **Abstract**

A terminal box of an embodiment includes a terminal box main body, a first connection terminal, and a second connection terminal. The terminal box main body is attached to a monolithic-structure solar cell element. The terminal box main body has a connection portion electrically connected to a terminal of the solar cell element. The first connection terminal is electrically connected to the connection portion. The first connection terminal is disposed at a distal end of a cable extending to the outside from the terminal box main body. The second connection terminal is electrically connected to the connection portion. The second connection terminal is formed on an outer surface of the terminal box main body. The second connection terminal is connectable to the first connection terminal.

## Description

### TECHNICAL FIELD

An embodiment of the present invention relates to a terminal box, a solar cell unit, and a solar cell unit connection body.

### BACKGROUND ART

A solar cell unit includes a solar cell element and a terminal box. The terminal box includes connection terminals. The connection terminals of adjacent solar cell units are connected to each other to form a solar cell unit connection body. It is required to reduce costs of the terminal box, the solar cell unit, and the solar cell unit connection body.

### Citation List

### Patent Document

Patent Document 1: PCT International Publication No. WO 2007/015346
Patent Document 2: Japanese Patent No. 3572265

### SUMMARY OF INVENTION

### Technical Problem

A problem to be solved by the present invention is to provide a terminal box, a solar cell unit, and a solar cell unit connection body in which costs can be reduced.

### Solution to Problem

A terminal box of an embodiment includes a terminal box main body, a first connection terminal, and a second connection terminal. The terminal box main body is attached to a monolithic-structure solar cell element. The terminal box main body has a connection portion electrically connected to a terminal of the solar cell element. The first connection terminal is electrically connected to the connection portion. The first connection terminal is disposed at a distal end of a cable extending to the outside from the terminal box main body. The second connection terminal is electrically connected to the connection portion. The second connection terminal is formed on an outer surface of the terminal box main body. The second connection terminal is connectable to the first connection terminal.

### BRIEF DESCRIPTION OF DRAWINGS

[FIG. 1] A plan view of a solar cell unit of a first embodiment.
[FIG. 2] A side cross-sectional view of a positive electrode terminal box.
[FIG. 3] A side cross-sectional view of a negative electrode terminal box.
[FIG. 4] A plan view of a parallel connection body.
[FIG. 5] A plan view of a solar cell unit connection body of the first embodiment.
[FIG. 6] A plan view of a solar cell unit connection body of a first modified example of the first embodiment.
[FIG. 7] A plan view of a solar cell unit of a second embodiment.
[FIG. 8] A plan view of a parallel connection body.
[FIG. 9] A plan view of a solar cell unit connection body of the second embodiment.
[FIG. 10] An explanatory view of a monolithic structure.

### DESCRIPTION OF EMBODIMENTS

Hereinafter, a terminal box, a solar cell unit, and a solar cell unit connection body of embodiments will be described with reference to the drawings.

### (First embodiment)

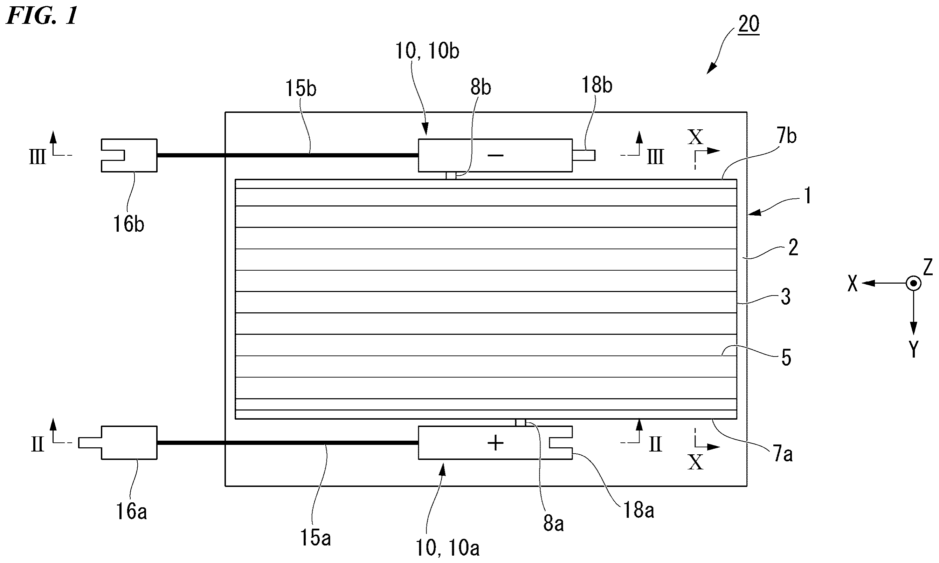

FIG. 1 is a plan view of a solar cell unit 20 of a first embodiment. The solar cell unit 20 includes a solar cell element (solar cell module) 1. The solar cell element 1 includes a semiconductor layer 3, a scribe line 5, a positive electrode 7a, a negative electrode 7b, and a terminal box 10.

In the present application, an X direction, a Y direction, and a Z direction of an orthogonal coordinate system are defined as follows. The X direction (first direction) is parallel to a surface of the solar cell element 1 and is a direction in which the scribe line 5 extends. The X direction is a left-right direction on a plane of paper. A +X direction (a first side in the first direction) is a leftward direction on the plane of paper, and a -X direction (a second side in the first direction) is a rightward direction on the plane of paper. The Y direction (second direction) is parallel to the surface of the solar cell element 1 and is a direction in which the positive electrodes 7a and the negative electrodes 7b are aligned. A +Y direction (a first side in the second direction) is a direction from the negative electrode 7b toward the positive electrode 7a, and a -Y direction (a second side in the second direction) is a direction from the positive electrode 7a toward the negative electrode 7b. The Z direction is a direction orthogonal to the surface of the solar cell element 1. A +Z direction is a direction in which the semiconductor layer 3 is formed on the substrate 2, and a -Z direction is a direction opposite to the +Z direction.

The semiconductor layer 3 is disposed on a surface of a substrate 2 such as a glass substrate or a film substrate having flexibility. The semiconductor layer 3 is a perovskite semiconductor, a transparent cuprous oxide (Cu₂O) semiconductor, or the like. The perovskite semiconductor includes a perovskite structure in at least a part thereof. The perovskite structure is a type of crystal structure, and has the same crystal structure as perovskite. Typically, a perovskite structure is composed of ions A, B, and X, and is represented by the following general expression (1).

ABX₃ ··· (1)

A primary ammonium ion can be used as the A ion. Specific examples include CH₃NH₃⁺, C₂H₅NH₃⁺, C₃H₇NH₃⁺, C₄H₉NH₃⁺, and HC(NH₂)₂⁺, with CH₃NH₃⁺ being preferred, but are not limited thereto. Cs⁺, Rb⁺, and 1,1,1-trifluoroethylammonium iodide (FEAI) are also preferable as the A ion, but the A ion is not limited thereto. As the B ion, divalent metal ions such as Pb²⁺ or Sn²⁺ can be used, but the B ion is not limited thereto. As the X ion, halide ions such as Cl⁻, Br⁻, or I⁻ can be used. A material constituting the ions A, B, or X may be a single material or a mixture. The constituent ions can function even if they do not necessarily match a stoichiometric ratio of ABX₃.

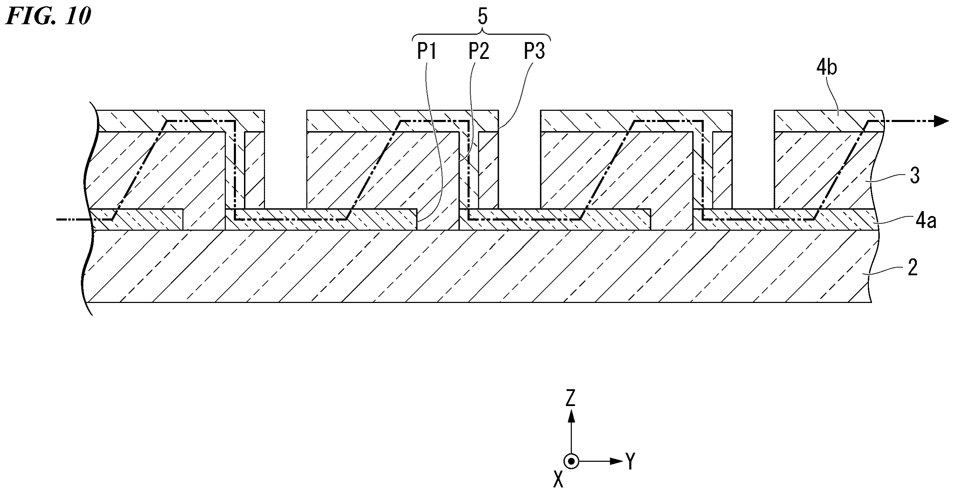

FIG. 10 is an explanatory view of a monolithic structure, and is a cross-sectional view along line X-X in FIG. 1.

The scribe line 5 corresponds to P1, P2, and P3 scribes of a so-called monolithic structure. That is, a lower electrode 4a is formed in the +Z direction of the substrate 2, and the lower electrode 4a is divided by the P1 scribe. Next, the semiconductor layer 3 is formed in the +Z direction of the lower electrode 4a, and the semiconductor layer 3 is divided by the P2 scribe. Next, an upper electrode 4b is formed in the +Z direction of the semiconductor layer 3, and the upper electrode 4b is divided by the P3 scribe.

As illustrated in FIG. 1, the scribe line 5 extends in the X direction. A plurality of scribe lines 5 are formed to be aligned in the Y direction. The semiconductor layer 3 is divided into a plurality of cells aligned in the Y direction by the plurality of scribe lines 5. The plurality of cells are electrically connected in series to form a so-called monolithic module. A power generation voltage of the solar cell element 1 is adjusted according to the number of cells divided by the scribe lines 5.

The positive electrode 7a is connected to an end part of the semiconductor layer 3 in the +Y direction. From the viewpoint of carrier collection efficiency, it is desirable that a width of the positive electrode 7a in the X direction be equal to a width of the semiconductor layer 3 in the X direction, but the present invention is not limited thereto. A positive electrode terminal 8a extends in the +Y direction from a center part of the positive electrode 7a in the X direction. The positive electrode terminal 8a is disposed at an end part of the solar cell element 1 in the +Y direction.

The negative electrode 7b is connected to an end part of the semiconductor layer 3 in the -Y direction. From the viewpoint of carrier collection efficiency, it is desirable that a width of the negative electrode 7b in the X direction be equal to the width of the semiconductor layer 3 in the X direction, but the present invention is not limited thereto. A negative electrode terminal 8b extends in the -Y direction from a center part of the negative electrode 7b in the X direction. The negative electrode terminal 8b is disposed at an end part of the solar cell element 1 in the -Y direction.

The solar cell unit 20 includes, as the terminal box (junction box) 10, a positive electrode terminal box 10a connected to the positive electrode terminal 8a, and a negative electrode terminal box 10b connected to the negative electrode terminal 8b. The positive electrode terminal box 10a and the negative electrode terminal box 10b are both formed in the +Z direction of the substrate 2, as is the semiconductor layer 3, but may also be formed in the -Z direction of the substrate 2, opposite to the semiconductor layer 3.

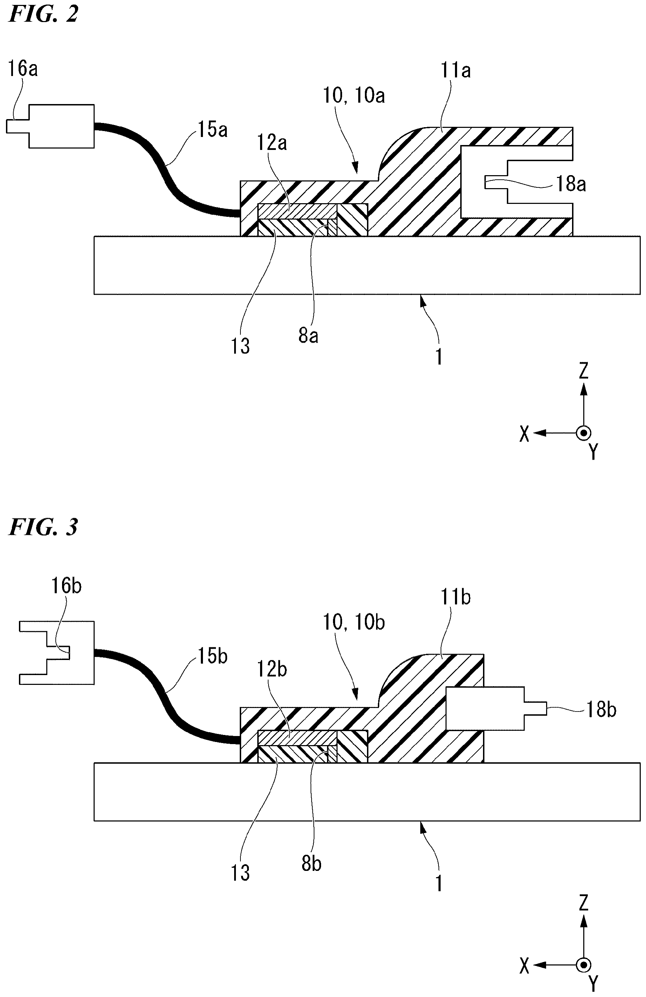

FIG. 2 is a side cross-sectional view of the positive electrode terminal box 10a along line II-II in FIG. 1.

The positive electrode terminal box 10a includes a positive electrode terminal box main body (terminal box main body) 11a, a first positive electrode connection terminal (first connection terminal) 16a, and a second positive electrode connection terminal (second connection terminal) 18a.

The positive electrode terminal box main body 11a is formed of a resin material or the like. The positive electrode terminal box main body 11a has a positive electrode connection portion (connection portion) 12a therein. The positive electrode connection portion 12a is a connection pad or the like. The positive electrode connection portion 12a is electrically connected to the positive electrode terminal 8a of the solar cell element 1 by soldering or the like. A connection portion between the positive electrode connection portion 12a and the positive electrode terminal 8a is sealed with a potting agent 13. The potting agent 13 is a resin adhesive or the like. The positive electrode terminal box main body 11a is attached to the solar cell element 1 by the potting agent 13. A longitudinal direction of the positive electrode terminal box main body 11a is approximately parallel to the X direction.

The first positive electrode connection terminal 16a is disposed at a distal end of a positive electrode cable (cable) 15a in the +X direction. The positive electrode cable 15a extends to the outside from an end part of the positive electrode terminal box main body 11a in the +X direction. An end part of the positive electrode cable 15a in the -X direction is connected to the positive electrode connection portion 12a. The first positive electrode connection terminal 16a is electrically connected to the positive electrode connection portion 12a via the positive electrode cable 15a. A length of the positive electrode cable 15a is equal to a width of the solar cell element 1 in the X direction.

The second positive electrode connection terminal 18a is a connection port, and is formed on an outer surface of the positive electrode terminal box main body 11a in the -X direction. The second positive electrode connection terminal 18a is electrically connected to the positive electrode connection portion 12a by wiring or the like (not illustrated).

The first positive electrode connection terminal 16a and the second positive electrode connection terminal 18a are connectors based on a standard such as MC4. The first positive electrode connection terminal 16a and the second positive electrode connection terminal 18a are connectable to each other. For example, the first positive electrode connection terminal 16a is a plug (pin, male), and the second positive electrode connection terminal 18a is a jack (socket, receptacle, female).

FIG. 3 is a side cross-sectional view of the negative electrode terminal box 10b along line III-III in FIG. 1.

The negative electrode terminal box 10b includes a negative electrode terminal box main body (terminal box main body) 11b, a first negative electrode connection terminal (first connection terminal) 16b, and a second negative electrode connection terminal (second connection terminal) 18b.

The negative electrode terminal box main body 11b is formed of a resin material or the like. The negative electrode terminal box main body 11b has a negative electrode connection portion (connection portion) 12b therein. The negative electrode connection portion 12b is a connection pad or the like. The negative electrode connection portion 12b is electrically connected to the negative electrode terminal 8b of the solar cell element 1 by soldering or the like. A connection portion between the negative electrode connection portion 12b and the negative electrode terminal 8b is sealed with a potting agent 13. The potting agent 13 is a resin adhesive or the like. The negative electrode terminal box main body 11b is attached to the solar cell element 1 by the potting agent 13. A longitudinal direction of the negative electrode terminal box main body 11b is approximately parallel to the X direction.

The first negative electrode connection terminal 16b is disposed at a distal end of the negative electrode cable (cable) 15b in the +X direction. A negative electrode cable 15b extends to the outside from an end part of the negative electrode terminal box main body 11b in the +X direction. An end part of the negative electrode cable 15b in the -X direction is connected to the negative electrode connection portion 12b. The first negative electrode connection terminal 16b is electrically connected to the negative electrode connection portion 12b via the negative electrode cable 15b. A length of the negative electrode cable 15b is equal to the width of the solar cell element 1 in the X direction.

The second negative electrode connection terminal 18b is a connection port and is formed on an outer surface of the negative electrode terminal box main body 11b in the -X direction. The second negative electrode connection terminal 18b is electrically connected to the negative electrode connection portion 12b by wiring or the like (not illustrated).

The first negative electrode connection terminal 16b and the second negative electrode connection terminal 18b are connectors based on a standard such as MC4. The first negative electrode connection terminal 16b and the second negative electrode connection terminal 18b are connectable to each other. For example, the first negative electrode connection terminal 16b is a jack (socket, receptacle, female), and the second negative electrode connection terminal 18b is a plug (pin, male). The first negative electrode connection terminal 16b may be a plug (pin, male) and the second negative electrode connection terminal 18b may be a jack (socket, receptacle, female), but in that case, the first positive electrode connection terminal 16a needs to be changed to a jack (socket, receptacle, female) and the second positive electrode connection terminal 18a to a plug (pin, male).

As described above, the first positive electrode connection terminal 16a of the positive electrode terminal box 10a is a plug based on a standard such as MC4. The first negative electrode connection terminal 16b of the negative electrode terminal box 10b is a jack based on a standard such as MC4. The positive electrode connection terminal 16a and the first negative electrode connection terminal 16b are connectable to each other.

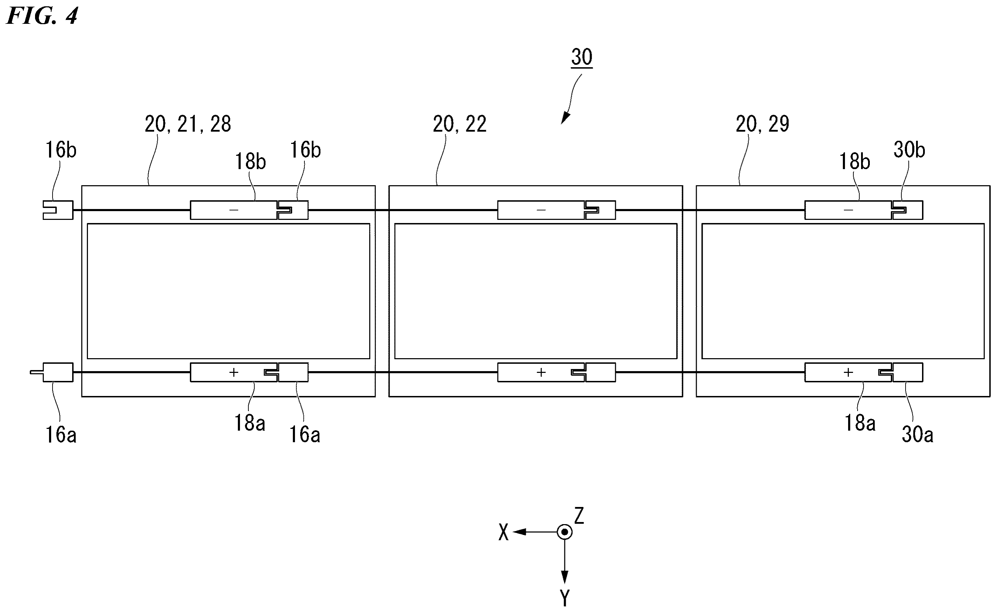

FIG. 4 is a plan view of a parallel connection body 30. The parallel connection body 30 has a configuration in which a plurality of solar cell units 20 are connected in parallel. The plurality of solar cell units 20 are disposed to be aligned in the X direction. A pair of solar cell units 20 adjacent to each other in the X direction are referred to as a first solar cell unit 21 and a second solar cell unit 22. The first solar cell unit 21 is positioned in the +X direction, and the second solar cell unit 22 is positioned in the -X direction. The second positive electrode connection terminal 18a of the first solar cell unit 21 and the first positive electrode connection terminal 16a of the second solar cell unit 22 are connected to each other. The second negative electrode connection terminal 18b of the first solar cell unit 21 and the first negative electrode connection terminal 16b of the second solar cell unit 22 are connected to each other.

The plurality of solar cell units 20 includes a first end part solar cell unit 28 and a second end part solar cell unit 29. The first end part solar cell unit 28 is provided at an end part in the +X direction, and the second end part solar cell unit 29 is provided at an end part in the -X direction. The parallel connection body 30 is connected to the outside by the first positive electrode connection terminal 16a and the first negative electrode connection terminal 16b of the first end part solar cell unit 28.

The parallel connection body 30 includes a positive electrode cap 30a and a negative electrode cap 30b. The positive electrode cap 30a is attached to the second positive electrode connection terminal 18a of the second end part solar cell unit 29. The negative electrode cap 30b is attached to the second negative electrode connection terminal 18b of the second end part solar cell unit 29. As the positive electrode cap 30a and the negative electrode cap 30b, commercially available products based on a standard such as MC4 can be used. Leakage current from the parallel connection body 30 is suppressed by the positive electrode cap 30a and the negative electrode cap 30b.

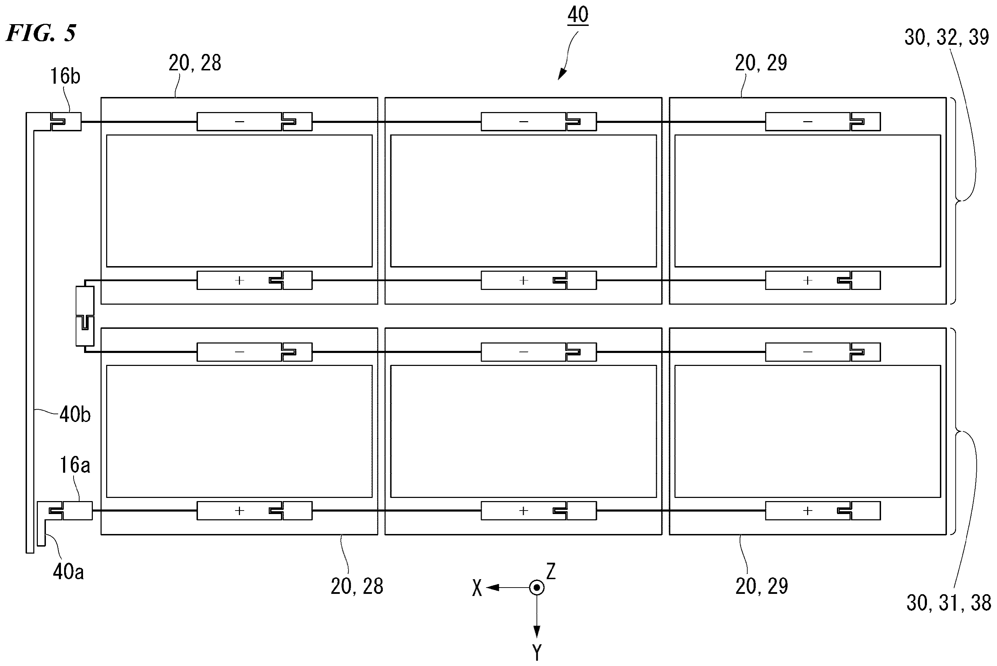

FIG. 5 is a plan view of a solar cell unit connection body 40 of the first embodiment. The solar cell unit connection body 40 is formed by connecting a plurality of parallel connection bodies 30 in series. The plurality of parallel connection bodies 30 are disposed to be aligned in the Y direction. A pair of parallel connection bodies 30 adjacent to each other in the Y direction are referred to as a first parallel connection body 31 and a second parallel connection body 32. The first parallel connection body 31 is positioned in the +Y direction, and the second parallel connection body 32 is positioned in the -Y direction. The first negative electrode connection terminal 16b of the first end part solar cell unit 28 of the first parallel connection body 31 and the first positive electrode connection terminal 16a of the first end part solar cell unit 28 of the second parallel connection body 32 are connected.

The plurality of parallel connection bodies 30 include a first end part parallel connection body 38 and a second end part parallel connection body 39. The first end part parallel connection body 38 is provided at an end part in the +Y direction, and the second end part parallel connection body 39 is provided at an end part in the -Y direction.

The solar cell unit connection body 40 has a positive electrode cord 40a and a negative electrode cord 40b. The positive electrode cord 40a is connected to the first positive electrode connection terminal 16a of the first end part solar cell unit 28 of the first end part parallel connection body 38. The negative electrode cord 40b is connected to the first negative electrode connection terminal 16b of the first end part solar cell unit 28 of the second end part parallel connection body 39. The positive electrode cord 40a and the negative electrode cord 40b are disposed in the +X direction of the solar cell unit connection body 40. The solar cell unit connection body 40 is connected to the outside by the positive electrode cord 40a and the negative electrode cord 40b.

As described above in detail, the solar cell unit 20 of the embodiment includes the solar cell element 1, the positive electrode terminal box 10a, and the negative electrode terminal box 10b. The solar cell element 1 includes a perovskite semiconductor, and has the positive electrode terminal 8a and the negative electrode terminal 8b. The positive electrode terminal box 10a is connected to the positive electrode terminal 8a, and the negative electrode terminal box 10b is connected to the negative electrode terminal 8b.

The positive electrode terminal box 10a includes the positive electrode terminal box main body 11a, the first positive electrode connection terminal 16a, and the second positive electrode connection terminal 18a. The positive electrode terminal box main body 11a is attached to the solar cell element 1 and has the positive electrode connection portion 12a that is electrically connected to the positive electrode terminal 8a of the solar cell element 1. The first positive electrode connection terminal 16a is electrically connected to the positive electrode connection portion 12a, and is disposed at a distal end of the positive electrode cable 15a extending to the outside from the positive electrode terminal box main body 11a. The second positive electrode connection terminal 18a is electrically connected to the positive electrode connection portion 12a, is formed on an outer surface of the positive electrode terminal box main body 11a, and is connectable to the first positive electrode connection terminal 16a.

The negative electrode terminal box 10b includes the negative electrode terminal box main body 11b, the first negative electrode connection terminal 16b, and the second negative electrode connection terminal 18b. The negative electrode terminal box main body 11b is attached to the solar cell element 1 and has the negative electrode connection portion 12b that is electrically connected to the negative electrode terminal 8b of the solar cell element 1. The first negative electrode connection terminal 16b is electrically connected to the negative electrode connection portion 12b, and is disposed at a distal end of the negative electrode cable 15b extending to the outside from the negative electrode terminal box main body 11b. The second negative electrode connection terminal 18b is electrically connected to the negative electrode connection portion 12b, is formed on an outer surface of the negative electrode terminal box main body 11b, and is connectable to the first negative electrode connection terminal 16b.

The first positive electrode connection terminal 16a and the first negative electrode connection terminal 16b are connectable to each other.

Compared to a typical Si solar cell, an amount of current generated by the solar cell element 1 including a perovskite semiconductor is small, and for practical use, a configuration in which the plurality of solar cell units 20 are connected in parallel is conceivable. Connection components that are generally available on the market are suitable for configurations in which solar cell units are connected in series, and when attempting to achieve parallel connection using such components, it is necessary to use, for example, a large number of special branch cables, which leads to disadvantages in terms of costs, the number of components, time and effort for connection, and the like. In the present embodiment, the positive electrode cable 15a of one solar cell unit 20 is extended so that the first positive electrode connection terminal 16a of one solar cell unit 20 is connected to the second positive electrode connection terminal 18a of the adjacent solar cell unit 20. The negative electrode cable 15b of one solar cell unit 20 is extended so that the first negative electrode connection terminal 16b of one solar cell unit 20 is connected to the second negative electrode connection terminal 18b of the adjacent solar cell unit 20. The plurality of solar cell units 20 can be easily connected in parallel. The number of solar cell units 20 connected in parallel can be easily changed. Special branch cables or the like for connecting the plurality of solar cell units 20 in parallel are not required. Since work errors during installation can also be prevented, it can contribute to shortening an installation period. As a result, costs of the solar cell unit connection body 40 can be reduced.

The positive electrode terminal box 10a and the negative electrode terminal box 10b are each constituted by two connection terminals and one cable. The positive electrode terminal box 10a and the negative electrode terminal box 10b have a simple structure, which makes it possible to reduce costs of the terminal box 10 and the solar cell unit 20.

The same positive electrode terminal box 10a and negative electrode terminal box 10b are attached to all of the solar cell units 20. When the positive electrode terminal box 10a and the negative electrode terminal box 10b are mass-produced, costs of the terminal box 10 and the solar cell unit 20 can be reduced.

A shape of the first positive electrode connection terminal 16a and a shape of the first negative electrode connection terminal 16b are different.

Connection errors among the plurality of solar cell units 20 are suppressed.

The solar cell element 1 has the scribe line 5 extending in the X direction. A direction parallel to the surface of the solar cell element 1 and orthogonal to the X direction is defined as the Y direction. The positive electrode terminal 8a is disposed at an end part of the solar cell element 1 in the +Y direction. The negative electrode terminal 8b is disposed at an end part of the solar cell element 1 in the -Y direction.

In a case in which the positive electrode terminal box 10a and the negative electrode terminal box 10b are integrated, routing wiring is required to route one of the positive electrode terminal 8a and the negative electrode terminal 8b close to the other terminal. In the embodiment, the positive electrode terminal box 10a and the negative electrode terminal box 10b are separate bodies, and no routing wiring is required. There is no need for an insulating film to be disposed between the routing wiring and the solar cell element 1, and no need for positioning work of the insulating film. It is possible to reduce costs of the solar cell unit 20.

In the first embodiment, the positive electrode cable 15a extends to the outside from the +X direction side of the positive electrode terminal box main body 11a. The second positive electrode connection terminal 18a is formed on the -X direction side of the positive electrode terminal box main body 11a. The negative electrode cable 15b extends to the outside from the +X direction side of the negative electrode terminal box main body 11b. The second negative electrode connection terminal 18b is formed on the -X direction side of the negative electrode terminal box main body 11b.

The positive electrode terminal box 10a and the negative electrode terminal box 10b are disposed parallel to the scribe line 5. The positive electrode terminal box 10a and the negative electrode terminal box 10b can be disposed close to the semiconductor layer 3. Lengths of the positive electrode terminal 8a and the negative electrode terminal 8b are reduced. It is possible to reduce costs of the solar cell unit 20.

In the first embodiment, both the positive electrode cable 15a and the negative electrode cable 15b extend in the +Y direction. Connection work of the plurality of solar cell units 20 is facilitated.

In the first embodiment, the solar cell unit connection body 40 includes the parallel connection body 30, the positive electrode cord 40a, and the negative electrode cord 40b.

In the parallel connection body 30, the plurality of solar cell units 20 described above are disposed to be aligned in the X direction. Of the pair of solar cell units 20 adjacent to each other in the X direction, the solar cell unit 20 positioned in the +X direction is referred to as the first solar cell unit 21, and the solar cell unit 20 positioned in the -X direction is referred to as the second solar cell unit 22. At this time, the second positive electrode connection terminal 18a of the first solar cell unit 21 and the first positive electrode connection terminal 16a of the second solar cell unit 22 are connected. At the same time, the second negative electrode connection terminal 18b of the first solar cell unit 21 and the first negative electrode connection terminal 16b of the second solar cell unit 22 are connected.

The plurality of parallel connection bodies 30 are disposed to be aligned in the Y direction. Of a pair of parallel connection bodies 30 adjacent to each other in the Y direction, the parallel connection body 30 positioned in the +Y direction is referred to as the first parallel connection body 31, and the parallel connection body 30 positioned in the -Y direction is referred to as a second parallel connection body 32. At this time, the first negative electrode connection terminal 16b of the solar cell unit 20 at an end part of the first parallel connection body 31 in the +X direction and the first positive electrode connection terminal 16a of the solar cell unit 20 at an end part of the second parallel connection body 32 in the +X direction are connected.

The positive electrode cord 40a is connected to the first positive electrode connection terminal 16a of the solar cell unit 20 at an end part in the +X direction of the parallel connection body 30 that is at an end part in the +Y direction. The negative electrode cord 40b is connected to the first negative electrode connection terminal 16b of the solar cell unit 20 at an end part in the +X direction of the parallel connection body 30 that is at an end part in the -Y direction.

The number of solar cell units 20 included in the parallel connection body 30 can be easily changed. The number of parallel connection bodies 30 included in the solar cell unit connection body 40 can be easily changed. It is possible to reduce costs of the solar cell unit connection body 40. The positive electrode cord 40a and the negative electrode cord 40b are both disposed in the +X direction of the solar cell unit connection body 40. Connection of the solar cell unit connection body 40 to the outside is facilitated.

The solar cell unit connection body 40 includes the positive electrode cap 30a attached to the second positive electrode connection terminal 18a and the negative electrode cap 30b attached to the second negative electrode connection terminal 18b of the solar cell unit 20 at an end part of the parallel connection body 30 in the -X direction.

Leakage current from the parallel connection body 30 of the solar cell unit connection body 40 is suppressed.

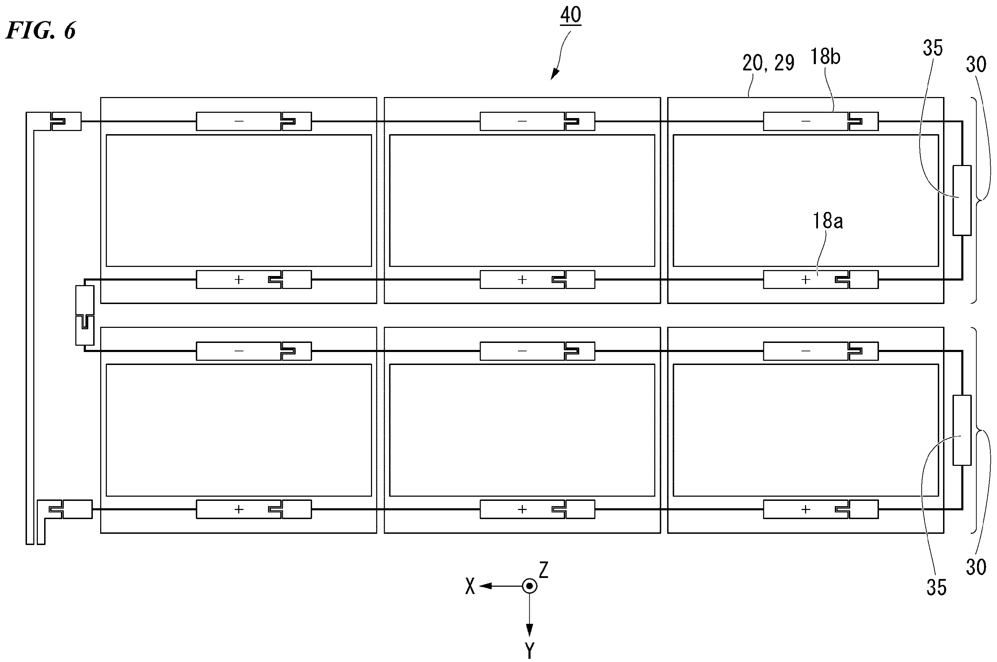

FIG. 6 is a plan view of a solar cell unit connection body 40 of a first modified example of the first embodiment. As described above, the solar cell unit connection body 40 of the first embodiment includes the positive electrode cap 30a and the negative electrode cap 30b. Alternatively, the solar cell unit connection body 40 of the first modified example includes a bypass diode 35. Description of portions of the first modified example that are the same as those in the first embodiment may be omitted.

The parallel connection body 30 includes the bypass diode 35. The bypass diode 35 is connected between the second positive electrode connection terminal 18a and the second negative electrode connection terminal 18b of the second end part solar cell unit 29 that is at an end part of the parallel connection body 30 in the -X direction.

Among the plurality of parallel connection bodies 30, some of the parallel connection bodies 30 may become unable to generate power. In this case, a current generated by the remaining parallel connection bodies 30 flows through the bypass diodes of some of the parallel connection bodies 30. It is possible to extract the current from the solar cell unit connection body 40.

The bypass diode 35 can be easily connected to the parallel connection body 30. There is no need for a special cable or the like for connecting the bypass diode 35 to the parallel connection body 30. It is possible to reduce costs of the solar cell unit connection body 40.

### (Second embodiment)

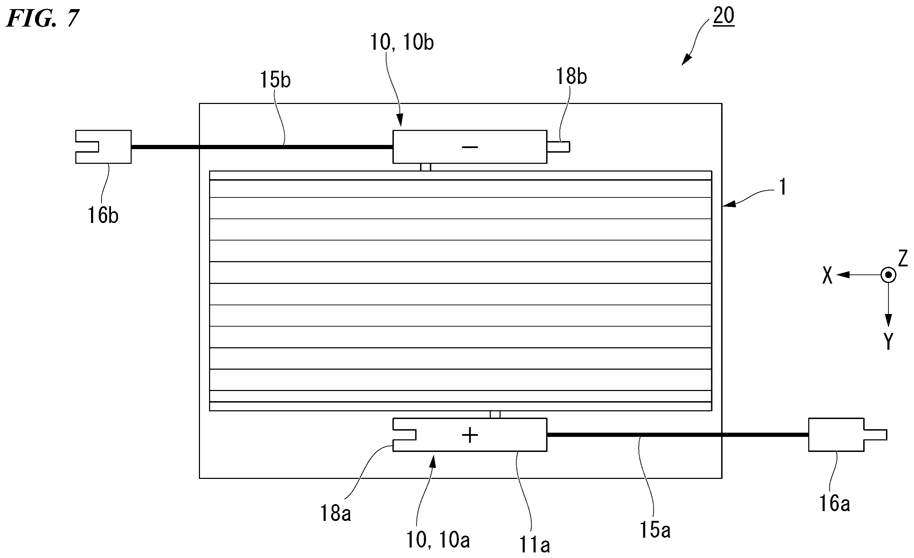

FIG. 7 is a plan view of a solar cell unit 20 of a second embodiment. As described above, in the solar cell unit 20 of the first embodiment, the positive electrode cable 15a and the negative electrode cable 15b extend in the same direction. In contrast, in the solar cell unit 20 of the second embodiment, the positive electrode cable 15a and the negative electrode cable 15b extend in opposite directions. Description of portions of the second embodiment that are the same as those in the first embodiment may be omitted.

A negative electrode terminal box 10b of the second embodiment is attached to a solar cell element 1 similarly to the first embodiment. A positive electrode terminal box 10a of the second embodiment is attached to the solar cell element 1 in an orientation reversed in the X direction from that of the first embodiment. The positive electrode cable 15a extends to the outside from an end part of a positive electrode terminal box main body 11a in the -X direction. A first positive electrode connection terminal 16a is disposed at a distal end of the positive electrode cable 15a in the -X direction. A second positive electrode connection terminal 18a is formed on an outer surface of the positive electrode terminal box main body 11a in the +X direction.

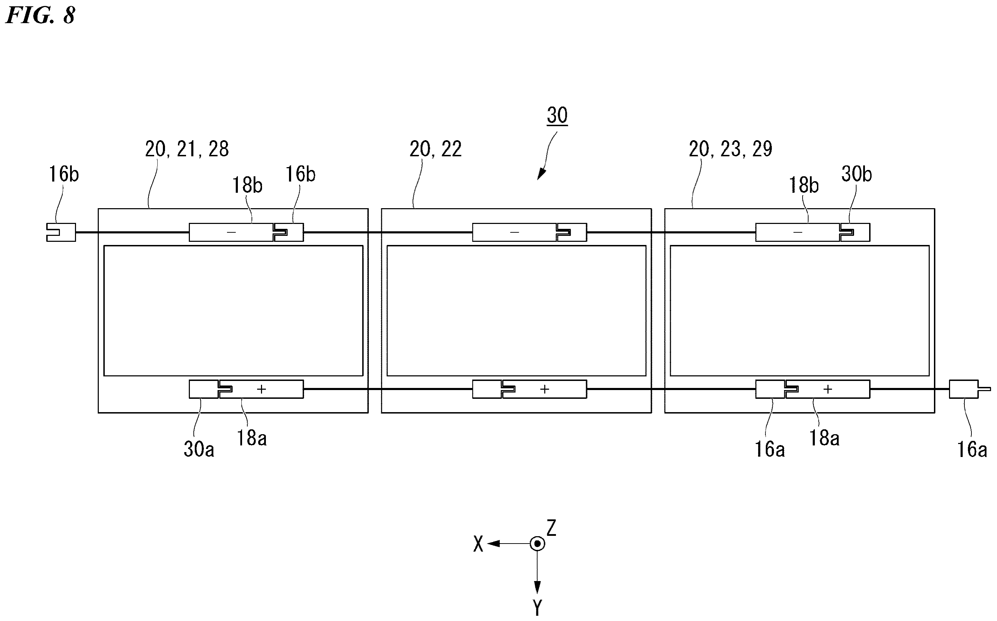

FIG. 8 is a plan view of a parallel connection body 30. The three solar cell units 20 aligned in the X direction are referred to as a first solar cell unit 21, a second solar cell unit 22 and a third solar cell unit 23. The first solar cell unit 21 is positioned in the +X direction, the third solar cell unit 23 is positioned in the -X direction, and the second solar cell unit 22 is positioned at a center. The first positive electrode connection terminal 16a of the second solar cell unit 22 and the second positive electrode connection terminal 18a of the third solar cell unit 23 are connected. A first negative electrode connection terminal 16b of the second solar cell unit 22 and a second negative electrode connection terminal 18b of the first solar cell unit 21 are connected.

The parallel connection body 30 is connected to the outside via the first positive electrode connection terminal 16a of a second end part solar cell unit 29 and the first negative electrode connection terminal 16b of a first end part solar cell unit 28.

A positive electrode cap 30a is attached to the second positive electrode connection terminal 18a of the first end part solar cell unit 28. A negative electrode cap 30b is attached to the second negative electrode connection terminal 18b of the second end part solar cell unit 29.

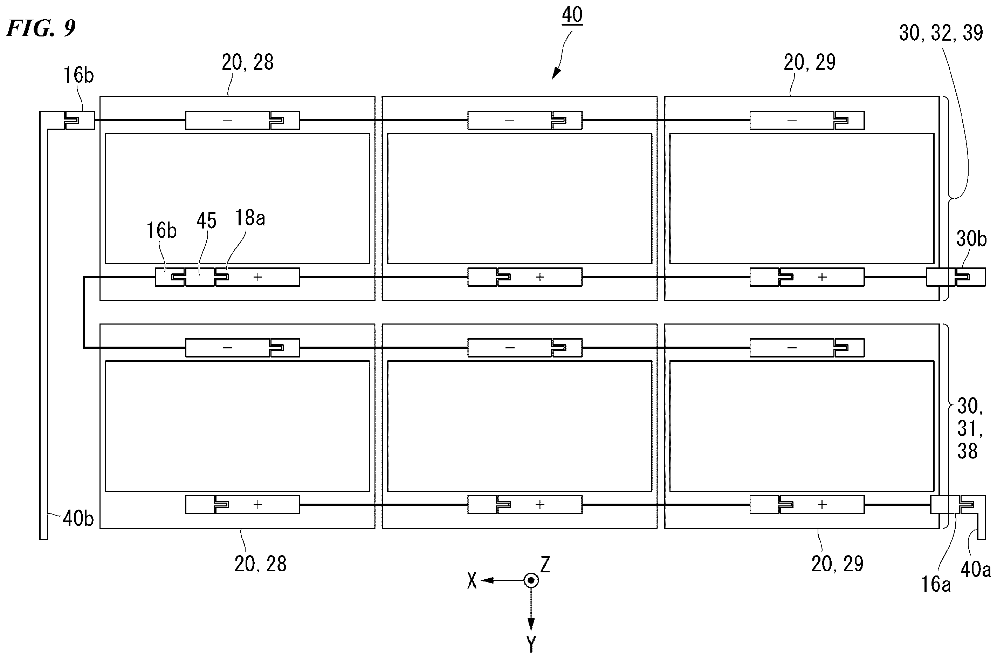

FIG. 9 is a plan view of a solar cell unit connection body 40 of the second embodiment. In a second parallel connection body 32, the positive electrode cap 30a attached to the second positive electrode connection terminal 18a of the first end part solar cell unit 28 is removed. In the second parallel connection body 32, the negative electrode cap 30b is attached to the first positive electrode connection terminal 16a of the second end part solar cell unit 29.

The first negative electrode connection terminal 16b of the first end part solar cell unit 28 of the first parallel connection body 31 and the second positive electrode connection terminal 18a of the first end part solar cell unit 28 of the second parallel connection body 32 are connected via a conversion connector 45. For example, both end parts of the conversion connector 45 are plugs (pins, male). As the conversion connector 45, commercially available products based on a standard such as MC4 can be used.

A positive electrode cord 40a is connected to the first positive electrode connection terminal 16a of the second end part solar cell unit 29 of a first end part parallel connection body 38. A negative electrode cord 40b is connected to the first negative electrode connection terminal 16b of the first end part solar cell unit 28 of a second end part parallel connection body 39.

Also in the second embodiment, similarly to the first embodiment, it is possible to reduce costs of a terminal box 10, the solar cell unit 20, and the solar cell unit connection body 40.

In the embodiment described above, the first positive electrode connection terminal 16a is a plug, the second positive electrode connection terminal 18a is a jack, the first negative electrode connection terminal 16b is a jack, and the second negative electrode connection terminal 18b is a plug. In contrast, the first positive electrode connection terminal 16a may be a jack, the second positive electrode connection terminal 18a may be a plug, the first negative electrode connection terminal 16b may be a plug, and the second negative electrode connection terminal 18b may be a jack.

According to at least one of the embodiments described above, the terminal boxes 10a and 10b have the terminal box main bodies 11a and 11b, the first connection terminals 16a and 16b, and the second connection terminals 18a and 18b. The first connection terminals 16a and 16b are disposed at distal ends of the cables 15a and 15b extending to the outside from the terminal box main bodies 11a and 11b. The second connection terminals 18a and 18b are formed on outer surfaces of the terminal box main bodies 11a and 11b. Thereby, it is possible to reduce costs of the terminal box 10, the solar cell unit 20, and the solar cell unit connection body 40.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

### REFERENCE SIGNS LIST

1 Solar cell element
5 Scribe line
8a Positive electrode terminal (terminal)
8b Negative electrode terminal (terminal)
10 Terminal box
10a Positive electrode terminal box (terminal box)
10b Negative electrode terminal box (terminal box)
11a Positive electrode terminal box main body (terminal box main body)
11b Negative electrode terminal box main body (terminal box main body)
12a Positive electrode connection portion (connection portion)
12b Negative electrode connection portion (connection portion)
15a Positive electrode cable (cable)
15b Negative electrode cable (cable)
16a First positive electrode connection terminal (first connection terminal)
16b First negative electrode connection terminal (first connection terminal)
18a Second positive electrode connection terminal (second connection terminal)
18b Second negative electrode connection terminal (second connection terminal)
20 Solar cell unit
21 First solar cell unit
22 Second solar cell unit
30 Parallel connection body
30a Positive electrode cap
30b Negative electrode cap
31 First parallel connection body
32 Second parallel connection body
35 Bypass diode
40 Solar cell unit connection body
40a Positive electrode cord
40b Negative electrode cord

## Claims

1. A terminal box comprising:
a terminal box main body attached to a monolithic-structure solar cell element and having a connection portion electrically connected to a terminal of the solar cell element;
a first connection terminal electrically connected to the connection portion and disposed at a distal end of a cable extending to the outside from the terminal box main body; and
a second connection terminal electrically connected to the connection portion, formed on an outer surface of the terminal box main body, and connectable to the first connection terminal.

2. The terminal box according to claim 1, wherein the solar cell element contains a perovskite semiconductor or a transparent cuprous oxide semiconductor.

3. A solar cell unit comprising:
a solar cell element having a monolithic structure and including a positive electrode terminal and a negative electrode terminal; and
a positive electrode terminal box connected to the positive electrode terminal and a negative electrode terminal box connected to the negative electrode terminal, wherein
the positive electrode terminal box includes:
a positive electrode terminal box main body attached to the solar cell element and having a positive electrode connection portion electrically connected to the positive electrode terminal of the solar cell element;
a first positive electrode connection terminal electrically connected to the positive electrode connection portion and disposed at a distal end of a positive electrode cable extending to the outside from the positive electrode terminal box main body; and
a second positive electrode connection terminal electrically connected to the positive electrode connection portion, formed on an outer surface of the positive electrode terminal box main body, and connectable to the first positive electrode connection terminal,
the negative electrode terminal box includes:
a negative electrode terminal box main body attached to the solar cell element and having a negative electrode connection portion electrically connected to the negative electrode terminal of the solar cell element;
a first negative electrode connection terminal electrically connected to the negative electrode connection portion and disposed at a distal end of a negative electrode cable extending to the outside from the negative electrode terminal box main body; and
a second negative electrode connection terminal electrically connected to the negative electrode connection portion, formed on an outer surface of the negative electrode terminal box main body, and connectable to the first negative electrode connection terminal, and
the first positive electrode connection terminal and the first negative electrode connection terminal are connectable to each other.

4. The solar cell unit according to claim 3, wherein a shape of the first positive electrode connection terminal and a shape of the first negative electrode connection terminal are different.

5. The solar cell unit according to claim 3 or 4, wherein
the solar cell element has a scribe line extending in a first direction, and
when a direction parallel to a surface of the solar cell element and orthogonal to the first direction is defined as a second direction, the positive electrode terminal is disposed at an end part on a first side of the solar cell element in the second direction, and the negative electrode terminal is disposed at an end part on a second side of the solar cell element in the second direction.

6. The solar cell unit according to claim 5, wherein
the positive electrode cable extends to the outside from a first side of the positive electrode terminal box main body in the first direction,
the second positive electrode connection terminal is formed on a second side of the positive electrode terminal box main body in the first direction,
the negative electrode cable extends to the outside from the first side of the negative electrode terminal box main body in the first direction, and
the second negative electrode connection terminal is formed on the second side of the negative electrode terminal box main body in the first direction.

7. The solar cell unit according to claim 3 or 4, wherein the solar cell element contains a perovskite semiconductor or a transparent cuprous oxide semiconductor.

8. A solar cell unit connection body, which is a solar cell unit connection body including a parallel connection body in which a plurality of solar cell units according to claim 6 are disposed to be aligned in the first direction, and when, of a pair of solar cell units adjacent to each other in the first direction, the solar cell unit on a first side in the first direction is defined as a first solar cell unit and the solar cell unit on a second side in the first direction is defined as a second solar cell unit, the second positive electrode connection terminal of the first solar cell unit is connected to the first positive electrode connection terminal of the second solar cell unit, and the second negative electrode connection terminal of the first solar cell unit is connected to the first negative electrode connection terminal of the second solar cell unit,
the solar cell unit connection body comprising:
a plurality of parallel connection bodies disposed to be aligned in the second direction, in which when, of a pair of parallel connection bodies adjacent to each other in the second direction, the parallel connection body on a first side in the second direction is defined as a first parallel connection body, and the parallel connection body on a second side in the second direction is defined as a second parallel connection body, the first negative electrode connection terminal of the solar cell unit at an end part on the first side of the first parallel connection body in the first direction is connected to the first positive electrode connection terminal of the solar cell unit at an end part on the first side of the second parallel connection body in the first direction;
a positive electrode cord connected to the first positive electrode connection terminal of the solar cell unit at an end part on the first side in the first direction in the parallel connection body at an end part on the first side in the second direction; and
a negative electrode cord connected to the first negative electrode connection terminal of the solar cell unit at an end part on the first side in the first direction in the parallel connection body at an end part on the second side in the second direction.

9. The solar cell unit connection body according to claim 8, further comprising a positive electrode cap attached to the second positive electrode connection terminal and a negative electrode cap attached to the second negative electrode connection terminal of the solar cell unit at an end part on the second side of the parallel connection body in the first direction.

10. The solar cell unit connection body according to claim 8, further comprising a bypass diode connected between the second positive electrode connection terminal and the second negative electrode connection terminal of the solar cell unit at an end part on the second side of the parallel connection body in the first direction.
